# EUROPEAN PATENT APPLICATION

(11) **EP 3 742 470 A2**
(43) Date of publication of application: **25.11.2020**
(21) Application number: 20175199.7
(22) Date of filing: 18.05.2020
(51) Int. Cl.: H01J 37/04, H01J 37/26, H01J 37/28

(54) **MULTI-BEAM SCANNING ELECTRON MICROSCOPE**

(30) Priority: 23.05.2019 US 201916421192
(71) Applicant: FEI Company, Hillsboro, OR 97124-5793 (US)
(72) Inventor: Mohammadi-Gheidari, Ali, 5602 BS Eindhoven (NL); Henstra, Alexander, 5602 BS Eindhoven (NL)
(74) Representative: Janssen, Francis-Paul

(57) **Abstract**

Variable multi-beam charged particle devices for inspection of a sample include a multi-beam source that produces a plurality of charged particle beamlets, an objective lens, a sample holder for holding the sample between the objective lens and the multi-beam source, and a focusing column that directs the plurality of charged particle beamlets so that they are incident upon the sample. The focusing column directs the plurality of charged beams such that there are one or more crossovers of the plurality of charged particle beamlets, where each crossover corresponds to a point where the plurality of charged particle beamlets pass through a common location. The variable multi-beam charged particle devices also include a variable aperture that is configured to vary the current of the plurality of charged particle beamlets, and which is located at a final crossover of the one or more crossovers that is most proximate to the sample.

## Description

### BACKGROUND OF THE INVENTION

Multi-beam charged particle systems for inspecting samples are becoming increasingly more desired due to their ability to greatly speed up the process of imaging/analyzing samples. This is due to their ability to irradiate multiple locations on a sample in parallel. This parallel irradiation allows for a huge reduction in the time it takes to image and/or analyze a sample. For example, a sample that would take a single beam charged particle system 24 hours to image might take a 196-beam system [Ref: Ali Mohammadi-Gheidari, PhD thesis, Delft University of Technology, 2013] less than 10 minutes. However, most current multi-beam systems are highly complex and very expensive. Specifically, most current multi-beam systems are specially designed to provide multi-beam functionality and are entirely separate systems from single beam charged particle systems.

### SUMMARY OF THE INVENTION

Variable current multi-beam charged particle devices for inspection of a sample according to the present disclosure include a multi-beam source that produces a plurality of charged particle beamlets, an objective lens, a sample holder for holding the sample between the objective lens and the multi-beam source, and a focusing column that directs and focuses the plurality of charged particle beamlets so that they are incident upon the sample. The focusing column is also configured to direct the plurality of charged beams such that there are one or more crossovers of the plurality of charged particle beamlets. Each crossover of the one or more crossovers corresponds to a point where the plurality of charged particle beamlets pass through a common location. The variable current multi-beam charged particle devices also include a variable aperture that is configured to vary the current of the plurality of charged particle beamlets, and which is located at the final crossover of the one or more crossovers that is most proximate to the sample.

### BRIEF DESCRIPTION OF THE DRAWINGS

The detailed description is described with reference to the accompanying figures. In the figures, the left-most digit(s) of a reference number identify the figure in which the reference number first appears. The same reference numbers in different figures indicates similar or identical items.
Figure 1 illustrates example variable current multi-beam charged particle systems for inspection of a sample.
Figure 2 depicts a sample process for inspecting a sample using a variable current multi-beam charged particle system.
Figure 3 illustrates an example variable current multi-beam charged particle system in which the focusing column includes a booster tube.
Figure 4 illustrates an example variable current multi-beam charged particle system in which the focusing column includes a plurality of lenses/apertures.
Figure 5 is a diagram that shows the variable aperture as having a small aperture.
Figure 6 is a diagram that shows the variable aperture as having a large aperture that has a bigger size and/or shape than the small aperture.
Figure 7 is a diagram that illustrates the variable current multi-beam charged particle system operating in a multi-beam mode.
Figure 8 is a diagram that illustrates the variable current multi-beam charged particle system operating in a single beam mode due to a translation of the variable aperture.
Figure 9 is a diagram that illustrates the variable current multi-beam charged particle system operating in a single beam mode due to a translation of the common crossover of the beamlets.

Like reference numerals refer to corresponding parts throughout the several views of the drawings.

### DETAILED DESCRIPTION OF EMBODIMENTS

Variable current multi-beam charged particle devices and system for inspection of a sample are disclosed. More specifically, the disclosure includes devices and systems that provide multi-beam charged particle functionality while also allowing the current of the multi-beam beamlets to be selectively varied, allow users to toggle between a single beam mode of operation and a multi-beam mode of operation, correct for aberration in the multi-beam beamlets, or a combination thereof. Additionally, the devices and systems described in the present disclosure can be implemented using current single beam charge particle systems/technology, potentially reducing the cost of the disclosed variable multi-beam charged particle system. This enables multi-beam functionality to be obtained by a greater number of scientists, potentially significantly increasing the speed of future scientific innovation.

Generally, in the figures, elements that are likely to be included in a given example are illustrated in solid lines, while elements that are optional to a given example are illustrated in broken lines. However, elements that are illustrated in solid lines are not essential to all examples of the present disclosure, and an element shown in solid lines may be omitted from a particular example without departing from the scope of the present disclosure.

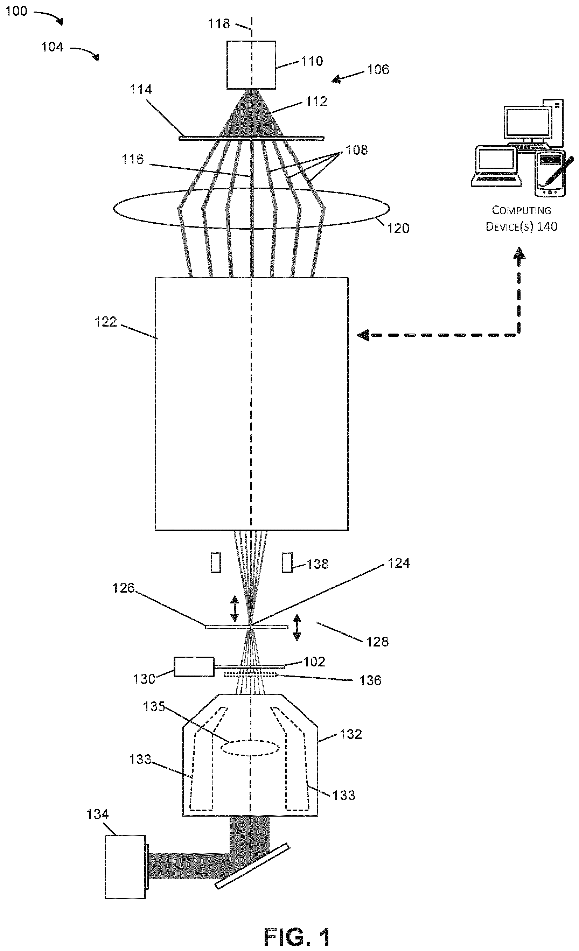

FIG. 1 is an illustration of example variable multi-beam charged particle system(s) 100 for inspection of a sample 102. The example variable multi-beam charged particle system(s) 100 may include electron microscope (EM) setups and/or charged particle microscope setups. In various embodiments the variable multi-beam charged particle system 100 may be or include one or more different types of EM and/or charged particle microscopes, such as, but not limited to, a scanning electron microscope (SEM), a scanning transmission electron microscope (STEM), a transmission electron microscope (TEM), a charged particle microscope (CPM), dual beam microscopy system, etc.

FIG. 1 shows the example EM and/or charged particle microscope setup(s) 100 as being a variable multi-beam SEM and STEM system 104 for inspecting the sample 102. However, a person having skill in the art would understand from FIG. 1 how the methods and system of the present disclosure would be embodied with other types of EM and/or charged particle microscopes. The example EM and/or charged particle microscope setup(s) 100 includes a multi-beam source 106 that emits a plurality of charged particle (e.g., electron) beamlets 108. The multi-beam source 106 may include a charged particle source 110 for generating a diverging beam 112 of charged particles (e.g., electrons), and an aperture lens array 114 that is configured to split the diverging beam 112 of charged particles into the plurality of charged particle beamlets 108. The plurality of charged particle beamlets 108 include a central beamlet 116 that is emitted by the multi-beam source 106 along an emission axis 118 and towards an accelerator lens 120. The emission axis 118 is a central axis that runs along the length of the example EM and/or charged particle microscope setup(s) 100 from the multi-beam source 106 and through the sample 102. For ease of understanding, the beamlets 108 are illustrated in FIGS. 1, 3, 4, and 7-9 as pencil beams. However, each of the beamlets 108 would have a diameter that varies as it passes through the example EM and/or charged particle microscope setup(s) 100. For example, the beamlets 108 may have a finite diameter in the plane of the variable aperture 126, and be focused to a point when they strike the sample 102.

The accelerator lens 120 accelerates /decelerates, focuses and/or directs the charged particle beamlets 108 towards a focusing column 122. The focusing column 122 focuses the charged particle beamlets from electron source 108 so that they are incident on sample 102. For example, the focusing column 122 may focus and/or direct the charged particle beamlets 108 from multi-beam source 106 such that each individual charged particle beamlet 108 is incident on sample 102 at a separate location. In some embodiments the focusing column 122 may include a booster tube, an arrangement of lenses and apertures, or a combination thereof. In addition to focusing the plurality of charged particle beamlets 108 so that they are incident upon the sample 102, the acceleration lens 120 and/or focusing column 122 direct the plurality of charged particle beamlets 108 so that their collective paths include one or more crossovers 124. Individual crossovers 124 correspond to a point where the paths of the plurality of charged particle beamlets 108 pass through a common location.

FIG. 1 further illustrates the example EM and/or charged particle microscope setup(s) 100 as including a variable aperture 126 that is positioned at a final crossover 124 that is most proximate to the sample 102. By being positioned at the final crossover 124, the variable aperture 126 can define and/or tune the objective angle of each beamlet of the plurality of charged particle beamlets 108. For example, by adjusting the size and/or shape of an aperture of the variable aperture 126 the current of each beamlet of the plurality of charged particle beamlets 108 when incident upon the sample 102 is adjusted. Specifically, the current of each individual beamlet is adjusted in correspondence with the adjustment of the aperture of the variable aperture 126.

In some embodiments, the variable aperture 126 may include a single aperture which has an adjustable size and/or shape. Such a variable aperture 126 can adjust the current of each of the plurality of charged particle beamlets 108 when incident on the sample 102 by adjusting the size and/or shape of the single aperture. Alternatively, or in addition, the variable aperture 126 may include multiple apertures having different sizes and/or shapes. For example, the variable aperture 126 may include a row of apertures having different diameters. Such a variable aperture 126 can adjust the current of each of the plurality of charged particle beamlets 108 when incident on the sample 102 by translating one or more of the multiple apertures so that a different aperture is positioned at the last crossover 124. For example, the current of each of the plurality of charged particle beamlets 108 may be reduced by shifting the apertures so that an aperture having a smaller size and/or shape is positioned at the last crossover 124. Similarly, the current of each of the plurality of charged particle beamlets 108 may be increased by shifting the apertures so that an aperture having a larger size and/or shape is positioned at the last crossover 124.

While the central beamlet 116 travels along the emission axis 118 through the accelerator lens 120 and the focusing column 122, the other beamlets of the plurality of charged particle beamlets 108 do not travel along the emission axis 118. Because of this, the other beamlets of the plurality of charged particle beamlets 108 are affected by off axial aberrations. By being positioned at the final crossover 124 the variable aperture 126 is also positioned in a coma free plane and/or dispersion free plane 128 between the sample 102 and the multi-beam source 106, which allows the variable aperture 126 to correct for geometric aberrations and/or chromatic aberration of the plurality of charged particle beamlets 108.

In addition to removing aberrations for the plurality of charged particle beamlets 108 and adjusting the current of each of the plurality of charged particle beamlets 108, in some embodiments the variable aperture 126 is further configured to allow the example EM and/or charged particle microscope setup(s) 100 to toggle between a multi-beam mode of operation and a single beam mode of operation. For example, in some embodiments the variable aperture 126 can be translated along the emission axis 118 from its position at the last crossover 124 to a new position that is not at the last crossover 124. In other words, when the variable aperture 126 is translated along the emission axis 118 to a position that is not at the last crossover 124 the example EM and/or charged particle microscope setup(s) 100 operates in a single beam mode. For example, when the variable aperture 124 is not positioned at the last crossover 124 only the central beamlet 116 may be allowed to pass through the variable aperture 126, meaning that only the central beamlet 116 is incident upon the sample 102. Alternatively, when the variable aperture 124 is not positioned at the last crossover 124 deflection coils or other beamlet manipulation means may be used to direct any individual beamlet of the beamlets 108 so that it passes through the variable aperture. In this way, any of the beamlets 108 may be caused to strike the sample when the example EM and/or charged particle microscope setup(s) 100 is operating in a single beam mode.

Alternatively, or in addition, the example EM and/or charged particle microscope setup(s) 100 may be configured to adjust the position of the last crossover 124. For example, one or more of the accelerator lens 120, the focusing column 122, or component elements thereof may be configured to adjust the paths of the plurality of charged particle beamlets 108 such that the position of the last crossover 124 is moved. In such embodiments, the last crossover 124 may be moved to a new position along the emission axis 118 so that the common location where each of the charged particle beamlets 108 pass is not located in an aperture of the variable aperture 126. When the last crossover 124 is located such a new position only the central beamlet 116 is able to pass through the variable aperture 126. Thus, when the last crossover 124 is located such a new position the example EM and/or charged particle microscope setup(s) 100 operates in a single beam mode.

FIG. 1 further illustrates the example EM and/or charged particle microscope setup(s) 100 as including a sample holder 130 that holds the sample 102 so that it is located between the multi-beam source 106 and the objective lens 132. The objective lens 132 focuses charged particles that are emitted by and/or transmitted through the sample 102 as a result of the plurality of charged particle beamlets 108 being incident on the sample 102 so that they are detected by a detector 134, which may be but is not limited to being a light detector. In some embodiments, the objective lens 132 may be composed of one or more of an inverted magnetic objective lens and an optical lens. For example, FIG. 1 illustrates the objective lens 132 as optionally including both a magnetic lens component 133 and an optical lens component 135. Alternatively, the objective lens 132 may include to an asymmetric magnetic lens.

In addition, the example EM and/or charged particle microscope setup(s) 100 is illustrated as including astigmatism correction and scan coils 138 for causing the plurality of charged particle beamlets 108 to scan the surface of the sample 102. For example, by operating scan coils 138, the direction of each of the plurality of charged particle beamlets 108 may be shifted so that each individual beamlet is focused onto a different location of the sample 102.

FIG. 1 also shows the example EM and/or charged particle microscope setup(s) 100 as optionally including a scintillator 136 positioned between the sample 102 and the objective lens 132. The scintillator 136 is configured to convert charged particles transmitted through and/or emitted by the sample 102 into light that can be focused by the objective lens 132 and onto the detector 134. In some embodiments, the scintillator 136 is a YAG screen.

FIG. 1 shows example EM and/or charged particle microscope setup(s) 100 as optionally including a computing device(s) 140. Those skilled in the art will appreciate that the computing devices 140 depicted in FIG. 1 are merely illustrative and are not intended to limit the scope of the present disclosure. The computing system and devices may include any combination of hardware or software that can perform the indicated functions, including computers, network devices, internet appliances, PDAs, wireless phones, controllers, oscilloscopes, amplifiers, etc. The computing devices 140 may also be connected to other devices that are not illustrated, or instead may operate as a stand-alone system. In addition, the functionality provided by the illustrated components may in some implementations be combined in fewer components or distributed in additional components. Similarly, in some implementations, the functionality of some of the illustrated components may not be provided and/or other additional functionality may be available.

The computing device(s) 140 may be a component of the example EM and/or charged particle microscope setup(s) 100, may be a separate device from the example EM and/or charged particle microscope setup(s) 100 which is in communication with the example EM and/or charged particle microscope setup(s) 100 via a network communication interface, or a combination thereof. For example, an example EM and/or charged particle microscope setup 100 may include a first computing device 140 that is a component portion of the example EM and/or charged particle microscope setup 100, and which acts as a controller that drives the operation of the example EM and/or charged particle microscope setup 100 (e.g., adjust the scanning location on the sample 102 by operating the scan coils 138, adjust the size/shape/position of the variable aperture 126, adjust the position of the final crossover, etc.). In such an embodiment the example EM and/or charged particle microscope setup(s) 100 may also include a second computing device 140 that is desktop computer separate from the example EM and/or charged particle microscope setup(s) 100, and which is executable to process data received from the detector 134 to generate images of the sample 102 and/or perform other types of analysis. The computing devices 140 may receive user selections via a keyboard, mouse, touchpad, touchscreen, etc.

The computing devices 140 include one or more processors configured to execute instructions, applications, or programs stored in a memory(s) accessible to the one or more processors. In some examples, the one or more processors may include hardware processors that include, without limitation, a hardware central processing unit (CPU), a graphics processing unit (GPU), and so on. While in many instances the techniques are described herein as being performed by the one or more processors, in some instances the techniques may be implemented by one or more hardware logic components, such as a field programmable gate array (FPGA), a complex programmable logic device (CPLD), an application specific integrated circuit (ASIC), a system-on-chip (SoC), or a combination thereof.

The memories accessible to the one or more processors are examples of computer-readable media. Computer-readable media may include two types of computer-readable media, namely computer storage media and communication media. Computer storage media may include volatile and non-volatile, removable, and non-removable media implemented in any method or technology for storage of information, such as computer readable instructions, data structures, program modules, or other data. Computer storage media includes, but is not limited to, random access memory (RAM), read-only memory (ROM), erasable programmable read only memory (EEPROM), flash memory or other memory technology, compact disc read-only memory (CD-ROM), digital versatile disk (DVD), or other optical storage, magnetic cassettes, magnetic tape, magnetic disk storage or other magnetic storage devices, or any other non-transmission medium that may be used to store the desired information and which may be accessed by a computing device. In general, computer storage media may include computer executable instructions that, when executed by one or more processing units, cause various functions and/or operations described herein to be performed. In contrast, communication media embodies computer-readable instructions, data structures, program modules, or other data in a modulated data signal, such as a carrier wave, or other transmission mechanism. As defined herein, computer storage media does not include communication media.

Those skilled in the art will also appreciate that items or portions thereof may be transferred between memory and other storage devices for purposes of memory management and data integrity. Alternatively, in other implementations, some or all of the software components may execute in memory on another device and communicate with the computing devices 140. Some or all of the system components or data structures may also be stored (e.g., as instructions or structured data) on a non-transitory, computer accessible medium or a portable article to be read by an appropriate drive, various examples of which are described above. In some implementations, instructions stored on a computer-accessible medium separate from the computing devices 140 may be transmitted to the computing devices 140 via transmission media or signals such as electrical, electromagnetic, or digital signals, conveyed via a communication medium such as a wireless link. Various implementations may further include receiving, sending or storing instructions and/or data implemented in accordance with the foregoing description upon a computer-accessible medium.

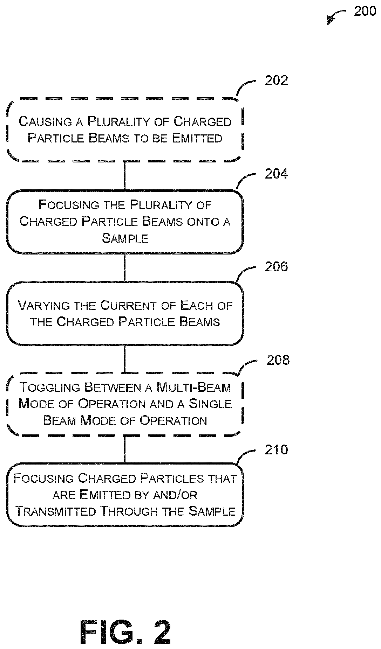

FIG. 2 is a flow diagram of illustrative processes illustrated as a collection of blocks in a logical flow graph, which represent a sequence of operations that can be implemented in hardware, software, or a combination thereof. In the context of software, the blocks represent computer-executable instructions stored on one or more computer-readable storage media that, when executed by one or more processors, perform the recited operations. Generally, computer-executable instructions include routines, programs, objects, components, data structures, and the like that perform particular functions or implement particular abstract data types. The order in which the operations are described is not intended to be construed as a limitation, and any number of the described blocks can be combined in any order and/or in parallel to implement the processes.

FIG. 2 is a flow diagram of an illustrative process 200 for inspecting a sample using a variable multi-beam charged particle system. The process 200 may be implemented in example EM and/or charged particle microscope setup(s) 100 and/or by the computing device(s) 140 described above, or in other environments and computing devices.

At 202, a plurality of charged particle beams are optionally caused to be emitted. Specifically, a multi-beam charged source may be caused to emit a plurality the charged particle beams toward a focusing column of the variable multi-beam charged particle system. The plurality of charged particle beamlets include a central beamlet that is emitted by the multi-beam source along an emission axis that runs from the multi-beam source and through the sample. In some embodiments, the multi-beam source includes a charged particle source for generating a diverging beam of charged particles (e.g., electrons), and an aperture lens array that is configured to split the diverging of charged particles into the plurality of charged particle beamlets.

At 204, the plurality of charged particle beams are focused onto the sample. Focusing the plurality of charged particle beams includes directing the plurality of charged particle beams such that there are one or more crossovers of the plurality of charged particle beamlets. In some embodiments, the focusing may be done using an arrangement of lenses and apertures, or a combination thereof. Alternatively, or in addition, the focusing is done at least in part by an acceleration lens and a booster tube.

At 206, the current of each of the charged particle beams is varied. Specifically, the current of each of the charged particle beamlets when it is incident upon the sample is varied by a variable aperture located at the final crossover. The final crossover is the crossover of the one or more crossovers that is most proximate to the sample. In some embodiments, the current of each of the charged particle beams is varied by adjusting the size and/or shape of an adjustable aperture of the variable aperture through which the final crossover passes. As the size and/or shape of the adjustable aperture is decreased, the current of each individual charged particle beamlet is correspondingly decreased. Similarly, the current of each individual charged particle beamlet is increased in correspondence with an increase in the size and/or shape of the adjustable aperture. In an alternative embodiment, the variable aperture includes a plurality of apertures having different sizes and/or shapes. In such embodiments, the current of the charged particle beamlets is varied by changing the aperture of the plurality of apertures that the final crossover passes through.

At 208, the variable multi-beam charged particle system is optionally toggled between a multi-beam mode of operation and a single beam mode of operation. For example, the variable multi-beam charged particle system may be designed so that it can operate in both a single beam mode of operation in which only a single beamlet of the plurality of charged particle beamlets is allowed to be incident upon the sample, and a multi-beam mode of operation in which a plurality of the charged particle beamlets is allowed to be incident upon the sample.

In some embodiments, toggling the variable multi-beam charged particle system between a multi-beam mode of operation and a single beam mode of operation includes moving the variable aperture along the emission axis. For example, if the variable aperture is translated along this emission axis so that it is no longer positioned at the final crossover, only the central beamlet that travels along the emission axis will be pass through the variable aperture. Thus, translating the variable aperture in this way causes the variable multi-beam charged particle system to switch from a multi-beam mode of operation to single beam mode of operation. In an alternative embodiment, the location of the final crossover may be moved so that it no longer positioned at the variable aperture.

At 210 charged particles that are emitted by and/or transmitted through the sample are focused. Specifically, the charged particles that are emitted by and/or transmitted through the sample are focused by an inverted objective lens located below the sample. Because the objective lens is inverted and positioned below the sample the variable aperture is able to be positioned within the coma free plane above the sample. This allows the variable aperture to correct for off axial aberrations of individual charged particle beamlets that are caused by not traveling along the emission axis of the variable multi-beam charged particle system.

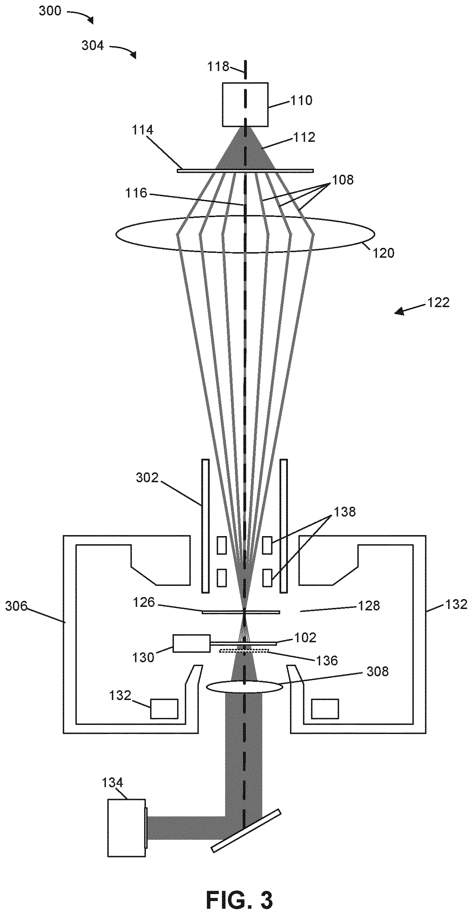

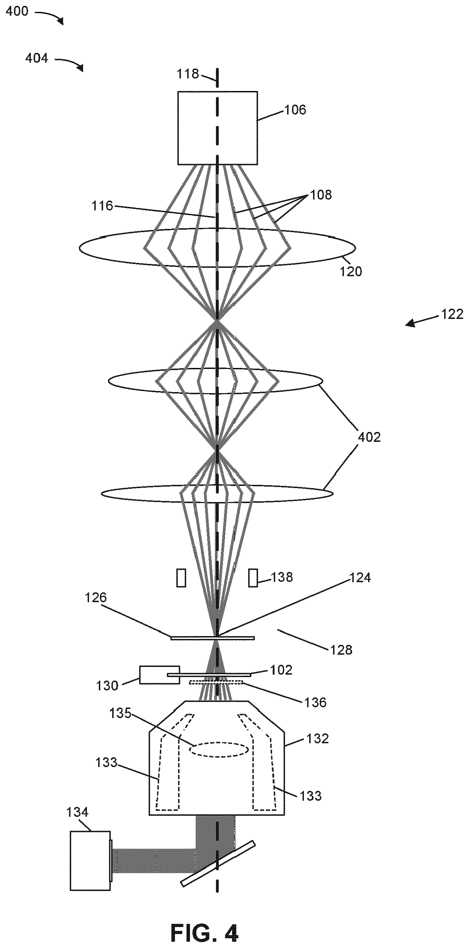

FIGS. 3 and 4 are illustrations of example variable current multi-beam charged particle system(s) 100 for inspection of a sample 102 where the focusing column 122 includes a booster tube 302 and a plurality of lenses/apertures 402, respectively.

FIG. 3 shows an example variable multi-beam charged particle system 304 in which the focusing column 122 includes a booster tube 302. The booster tube 302 is configured to be selectively switched between an active state where a high voltage is applied to the booster tube 302, and a ground state. The booster tube 302 may be composed of a tube that encapsulates the middle components of the focusing column 122, and which can be set to a higher voltage level than other regions of the focusing column 122 and/or variable multibeam charged particle system 304. Alternatively, the booster tube 302 may be capable of being set to a higher voltage level but does not physically encapsulate the components of the focusing column 122. By passing through the higher voltage booster tube 302, the plurality of charged particle beams 108 experience less beam spread (i.e., less electron to electron interactions that inversely affects the performance of the microscope) as they traverse the focusing column 122. This is because the higher voltage booster tube 302 applies a repulsive force inward that offsets the repulsive force between charged particles that make up individual beamlets. Additionally, the higher voltage booster tube 302 generates an electrostatic lens action because of the potential difference between booster tube 302 and surrounding electrodes/sample 102. In fact, in some embodiments this electrostatic lens action may be combined with a magnetic lens below the booster tube 302 and/or sample 102 may act as an objective lens. Although not pictured in FIG. 3, the variable multi-beam charged particle system 304 may optionally include an additional lens (e.g., an electron lens) between the booster tube 302 and the variable aperture 126. Alternatively, or in addition, the additional lens may include or correspond to a shield electrode, where a potential difference between the shield electrode and the booster tube 302 creates a lensing effect.

FIG. 3 further illustrates objective lens 132 as being an asymmetric magnetic lens 306 setup. The asymmetric magnetic lens setup 306 is shown as including a magnetic lens 308 made of soft magnetic iron, and an optical lens 308 (e.g., a glass lens). FIG. 3 also shows the example variable multi-beam charged particle system 304 as optionally including two layers of scan coils 138 that have a pivot point in the variable aperture 126.

FIG. 4 shows an example variable multi-beam charged particle system 404 in which the focusing column 122 includes a plurality of lenses/apertures 402. The plurality of lenses/apertures can include one or more of a condenser lens, focusing aperture, scan coils 138, an upper objective lens, etc. that together focus the plurality of charged particle beamlets from multibeam source 106 onto sample 102.

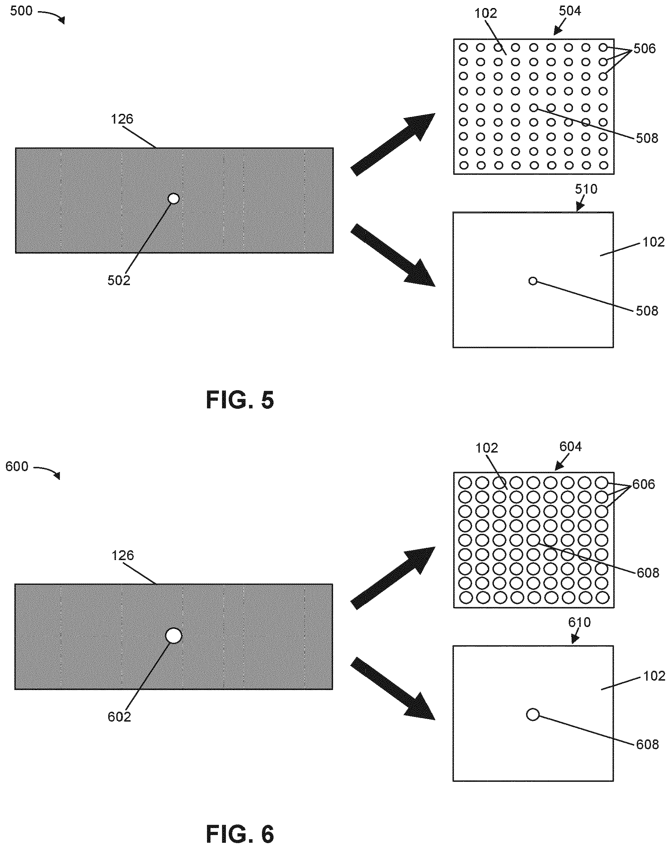

FIGS. 5 and 6 are diagrams 500 and 600 that illustrate the variable aperture 126 varying the current of the plurality of charged particle beams. FIG. 5 is a diagram 500 that shows variable aperture 126 as having a small aperture 502. FIG. 5 also includes a first depiction 504 of a section of sample 102 when the variable multi-beam charged particle system is operating in a multi-beam mode (i.e., when the plurality of charged particle beams are incident upon the sample). As can be seen in depiction 504, the plurality of charged particle beams form an array 506 of irradiated/illuminated portions of the sample 102. The array 506 includes a central irradiated/illuminated portion 508 that is created with then central charged particle beam that travels along the emission axis of the variable multi-beam charged particle system is incident upon the sample 102. FIG. 5 also includes a second depiction 510 of the sample 102 when the variable multi-beam charged particle system is operating in a single beam mode. That is, the second depiction 510 shows a portion of the section of sample 102 upon which only the central charged particle beam 508 is incident upon the sample 102.

Similarly, FIG. 6 is a diagram 600 that shows variable aperture 126 as having a large aperture 602 that has a bigger size and/or shape than the small aperture 502. FIG. 6 also includes a first depiction 604 of a section of sample 102 when the variable multi-beam charged particle system is operating in a multi-beam mode (i.e., when the plurality of charged particle beams are incident upon the sample). As can be seen in depiction 604, the plurality of charged particle beams form an array 606 of irradiated/illuminated portions of the sample 102. Because the large aperture 602 has a bigger size and/or shape than the small aperture 502, a larger portion of each of the plurality of charged particle beams is allowed to pass through the variable aperture 126, resulting in a greater beam current when incident upon the sample 102. As can be seen in depiction 604, this results in each irradiated/illuminated portion of array 606 as having a larger size/shape than the array 506 shown in FIG. 5. The array 606 includes a central irradiated/illuminated portion 608 that is created with then central charged particle beam that travels along the emission axis of the variable multi-beam charged particle system is incident upon the sample 102. FIG. 6 also includes a second depiction 610 of the sample 102 when the variable multi-beam charged particle system is operating in a single beam mode. That is, the second depiction 610 shows a portion of the section of sample 102 upon which only the central charged particle beam 608 is incident upon the sample 102.

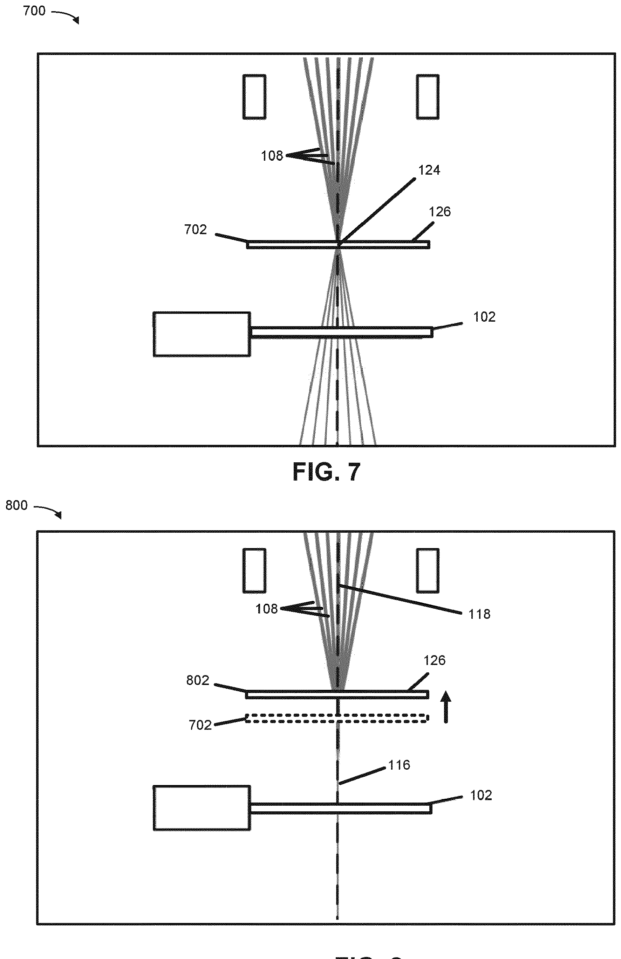

FIG. 7 is a diagram 700 that illustrates the variable multi-beam charged particle system operating in a multi-beam mode. FIG. 7 shows the plurality of charged particle beams 108 converging to a final crossover 124. FIG. 7 also shows the variable aperture 126 located at a first position such that the final crossing point 124 passes through an aperture in the variable aperture 126. This allows each of the plurality of charged particle beams to pass through the variable aperture 126 and be incident on the sample 102.

FIG. 8 is a diagram 800 that illustrates the variable multi-beam charged particle system operating in a single beam mode due to a translation of the variable aperture. FIG. 8 shows the variable aperture 126 in a second position 802 that is different from the first position 702. Specifically, FIG. 8 shows the variable aperture 126 having been moved away from the sample 102 along the emission axis 118. As can be seen, because the variable aperture 126 is no longer located at the final crossover 124, only the central beamlet 116 that travels along the emission axis 118 is able to pass through the aperture of the variable aperture 124. Because the remainder of the charged particle beams 108 are blocked by the variable aperture, the variable multi-beam charged particle system operates in a single beam mode when the variable aperture is in the second position 802.

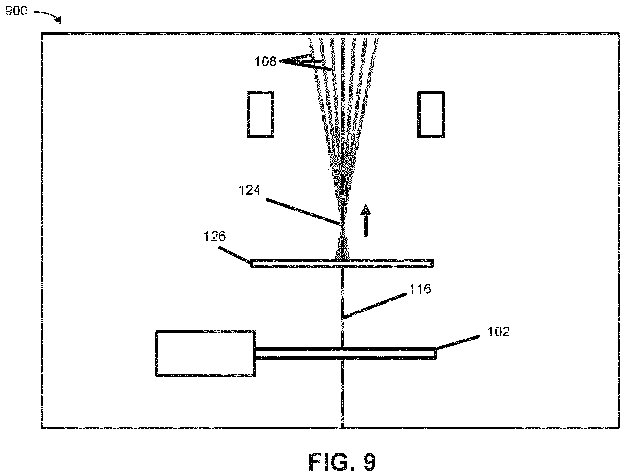

FIG. 9 is a diagram 900 that illustrates the variable multi-beam charged particle system operating in a single beam mode due to a translation of the common crossover of the beamlets. Specifically, FIG. 9 shows the variable multi-beam charged particle system after it has modified the focus of the system so that the position of the final crossover 124 is no longer located at the variable aperture 126. Because the final crossover 124 is no longer located at the variable aperture 126 only the central beamlet 116 is able to pass through the aperture of the variable aperture 124 and the remainder of the plurality of charged particle beamlets 108 are blocked by the variable aperture 124. Thus, the variable multi-beam charged particle system operates in a single beam mode when the position of the final crossover 124 is no longer located at the variable aperture 126.

Examples of inventive subject matter according to the present disclosure are described in the following enumerated paragraphs.

A1. A variable multi-beam charged particle device for inspection of a sample, comprising: a multi-beam source configured to produce a plurality of charged particle beamlets; a sample holder for holding the sample; a focusing column configured to direct the plurality of charged particle beamlets to be incident upon the sample; one or more crossovers of the plurality of charged particle beamlets, wherein each crossover of the one or more crossovers corresponds to a point where the plurality of charged particle beamlets pass through a common location; a variable aperture located at a final crossover of the one or more crossovers that is most proximate to the sample, wherein the variable aperture is configured to vary the current of the plurality of charged particle beamlets; and an objective lens, wherein the sample is located between the objective lens and the multi-beam source.

A2. The variable multi-beam charged particle device of paragraph A1, wherein the one or more crossovers include a plurality of crossovers between the multi-beam source and the sample.

A3. The variable multi-beam charged particle device of any of paragraphs A1-A2, wherein the one or more crossovers include is a single crossover.

A4. The variable multi-beam charged particle device of any of paragraphs A1-A3, wherein the multi-beam source comprises: a source for producing a beam of charged particles; and an illuminator configured to convert the beam of charged particles into the plurality of charged particle beamlets.

A5. The variable multi-beam charged particle device of any of paragraphs A1-A4, wherein the variable aperture is configured to toggle the device between a single beam mode of operation and a multi-beam mode of operation.

A5.1. The variable multi-beam charged particle device of paragraph A5, wherein the variable multi-beam charged particle device is configured to translate the variable aperture between a first location and a second location, and wherein: the variable multi-beam charged particle device operates in the multi-beam mode of operation when the variable aperture is in the first location; and the variable multi-beam charged particle device operates in the single beam mode of operation when the variable aperture is in the second location.

A5.2. The variable multi-beam charged particle device of paragraph A5, wherein the variable multi-beam charged particle device is configured to translate the final crossover between a first location and a second location, and wherein: the variable multi-beam charged particle device operates in the multi-beam mode of operation when the final crossover is in the first location; and the variable multi-beam charged particle device operates in the single beam mode of operation when the final crossover is in the second location.

A6. The variable multi-beam charged particle device of any of paragraphs A1-A5.2, wherein the variable aperture is positioned in a coma free region between the sample and the multi-beam source.

A7. The variable multi-beam charged particle device of any of paragraphs A1-A6, wherein the variable aperture is configured to correct lens aberration resultant from a subset of the plurality of charged particle beamlets not traveling along a central axis of the focusing column.

A8. The variable multi-beam charged particle device of any of paragraphs A1-A7, wherein the variable aperture comprises at least a first aperture and a second aperture.

A8.1. The variable multi-beam charged particle device of paragraph A8, wherein the first aperture has a different size and/or shape from the second aperture.

A8.2. The variable multi-beam charged particle device of any of paragraphs A8-A8.1, wherein the variable multi-beam charged particle device is configured to translate the variable aperture between a first position and a second position.

A8.2.1. The variable multi-beam charged particle device of paragraph A8.2, wherein: when the variable aperture is in the first position one or more charged particle beamlets of the plurality of charged particle beamlets pass through the first aperture, and when the variable aperture is in the second position the one or more charged particle beamlets of the plurality of charged particle beamlets pass through the second aperture.

A8.2.2. The variable multi-beam charged particle device of any of paragraphs A8-A8.1, wherein: when the variable aperture is in the first position the final crossover passes through the first aperture, and when the variable aperture is in the second position the final crossover passes through the second aperture.

A8.2.3. The variable multi-beam charged particle device of any of paragraphs A8.2.1-A8.2.2, wherein: when the final crossover passes and/or the one or more charged particle beamlets of the plurality of charged particle beamlets pass through the first aperture, the plurality of charged particle beamlets have a first current when incident upon the sample; and when the final crossover passes and/or the one or more charged particle beamlets of the plurality of charged particle beamlets pass through the second aperture, the plurality of charged particle beamlets have a second current when incident upon the sample that is different from the first current.

A9. The variable multi-beam charged particle device of any of paragraphs A1-A8.2.3, wherein the variable aperture comprises an adjustable aperture.

A9.1. The variable multi-beam charged particle device of paragraph A9, wherein the adjustable aperture is configured to switch between a first state and a second state, and wherein the adjustable aperture has a different size and/or shape when it is in the second state than when it is in the first state.

A9.1.1. The variable multi-beam charged particle device of paragraph A9.1, wherein: when the adjustable aperture is in the first state, the plurality of charged particle beamlets have a first current when incident upon the sample; and when the adjustable aperture is in the second state, the plurality of charged particle beamlets have a second current when incident upon the sample that is different from the first current.

A10. The variable multi-beam charged particle device of any of paragraphs A1-A9.1.1, further comprising a scintillator positioned between the sample and the objective lens and configured to convert charged particles transmitted through and/or emitted by the sample into light.

A10.1. The variable multi-beam charged particle device of paragraph A10, wherein the scintillator is a YAG screen.

A10.2. The variable multi-beam charged particle device of any of paragraphs A10-A10.1, further comprising a detector for detecting the light from the scintillator.

A10.2.1. The variable multi-beam charged particle device of paragraph A10.2, wherein the light from the scintillator passes through the objective lens before being detected by the detector.

A11. The variable multi-beam charged particle device of any of paragraphs A1-A10.2.1, wherein the variable multi-beam charged particle device is a transmission inspection system.

A12. The variable multi-beam charged particle device of any of paragraphs A1-A11, wherein the objective lens is a magnetic objective lens.

A13. The variable multi-beam charged particle device of any of paragraphs A1-A12, wherein the focusing column comprises a booster tube.

B1. A method for adjusting the current of a variable multi-beam charged particle device for inspection of a sample, the method comprising: focusing a plurality of charged particle beams from a multi-beam source to be incident upon the sample, wherein focusing the plurality of charged particle beams comprises directing the plurality of charged particle beams such that there are one or more crossovers of the plurality of charged particle beamlets, wherein each crossover of the one or more crossovers corresponds to a point where the plurality of charged particle beamlets pass through a common location; varying the current of each of the charged particle beams via a variable aperture located at a final crossover of the one or more crossovers that is most proximate to the sample; and focusing, by an objective lens and onto a detector, charged particles that are emitted by and/or transmitted through the sample.

B2. The method of paragraph B1, wherein the variable aperture comprises an adjustable aperture, the final crossover of the one or more crossovers passes through the adjustable aperture, and wherein the varying the current of each of the charged particle beams comprises adjusting the size and/or shape of the variable aperture.

B2.1. The method of paragraph B2, wherein the varying the current of each of the charged particle beams comprises switching the adjustable aperture between a first state where the adjustable aperture has a first size and/or shape and a second state where the adjustable aperture has a second size and/or shape.

B2.1.1. The method of paragraph B2.1, wherein the second size and/or shape is a different size from the first size and/or shape.

B2.1.2. The method of any of paragraphs B2.1-B2.1.1, wherein the second size and/or shape is a different size from the first size and/or shape.

B2.1.3. The method of any of paragraphs B2.1-B2.1.2, wherein: when the adjustable aperture is in the first state, the plurality of charged particle beamlets have a first current when incident upon the sample; and when the adjustable aperture is in the second state, the plurality of charged particle beamlets have a second current when incident upon the sample that is different from the first current.

B3. The method of paragraph B1, wherein the variable aperture comprises at least a first aperture and a second aperture.

B3.1. The method of paragraph B3, wherein the first aperture has a different size and/or shape from the second aperture.

B3.2. The method of any of paragraphs B3-B3.1, wherein the varying the current of each of the charged particle beams comprises translating the variable aperture between: a first position where one or more charged particle beamlets of the plurality of charged particle beamlets pass through the first aperture; and a second position where the one or more charged particle beamlets of the plurality of charged particle beamlets pass through the second aperture.

B3.2.1. The method of paragraph B3.2, wherein: when the variable aperture is in the first position the final crossover passes through the first aperture, and when the variable aperture is in the second position the final crossover passes through the second aperture.

B3.2.2. The method of any of paragraphs B3.2-B3.2.1, wherein: when the final crossover passes and/or the one or more charged particle beamlets of the plurality of charged particle beamlets pass through the first aperture, the plurality of charged particle beamlets have a first current when incident upon the sample; and when the final crossover passes and/or the one or more charged particle beamlets of the plurality of charged particle beamlets pass through the second aperture, the plurality of charged particle beamlets have a second current when incident upon the sample that is different from the first current.

B4. The method of any of paragraphs B1-B3, further comprising toggling the variable multi-beam charged particle device between a multi-beam mode of operation and a single beam mode of operation.

B4.1. The method of paragraph B4, wherein toggling the variable multi-beam charged particle device between a multi-beam mode of operation and a single beam mode of operation comprises translating along a central axis of the variable multi-beam charged particle device between a first location and a second location.

B4.1.1. The method of paragraph B4.1, wherein when the variable aperture is in the first location the final crossover passes through the variable aperture, and when the variable aperture is in the second location only a single beamlet of the plurality of charged particle beamlets passes through the variable aperture.

B4.1.2. The method of any of paragraphs B4.1-B4.1.1, wherein the variable multibeam charged particle device operates in the multibeam mode of operation when the variable aperture is in the first location; and the variable multibeam charged particle device operates in the single beam mode of operation when the variable aperture is in the second location.

B4.2. The method of paragraph B4, wherein toggling the variable multi-beam charged particle device between a multi-beam mode of operation and a single beam mode of operation comprises translating the final crossover between a first location and a second location.

B4.2.1. The method of paragraph B4.2, wherein when the final crossover is in the first location the final crossover passes through the variable aperture, and when the final crossover is in the second location only a single beamlet of the plurality of charged particle beamlets passes through the variable aperture.

B4.2.2. The method of any of paragraphs B4.2-B4.2.1, wherein the variable multibeam charged particle device operates in the multibeam mode of operation when the final crossover is in the first location; and the variable multibeam charged particle device operates in the single beam mode of operation when the final crossover is in the second location.

B5. The method of any of paragraphs B1-B4.2.2, further comprising causing a multi-beam source to produce the plurality of charged particle beamlets.

B6. The method of any of paragraphs B1-B5, wherein varying the current of each of the charged particle beams comprises correcting lens aberration resultant from a subset of the plurality of charged particle beamlets not traveling along a central axis of the variable multi-beam charged particle device.

C1. Use of the variable multibeam charged particle device of any of paragraphs A1-A13 to perform the method of any of paragraphs B1-B6.

D1. A computer readable media storing non-transitory computer readable instructions that, when executed by one or more processors, cause the variable multi-beam charged particle device to perform the method of any of paragraphs B1-B6.

## Claims

1. A variable multibeam charged particle device for inspection of a sample, comprising:
a multibeam source configured to produce a plurality of charged particle beamlets;
a sample holder for holding the sample;
a focusing column configured to direct the plurality of charged particle beamlets to be incident upon the sample, wherein the focusing column directs the plurality of charged beamlets such that there are one or more crossovers of the plurality of charged particle beamlets, wherein each crossover of the one or more crossovers corresponds to a point where the plurality of charged particle beamlets pass through a common location;
a variable aperture located at a final crossover of the one or more crossovers that is most proximate to the sample, wherein the variable aperture is configured to vary the current of the plurality of charged particle beamlets; and
an objective lens, wherein the sample is located between the objective lens and the multibeam source.

2. The variable multibeam charged particle device of claim 1, wherein the variable aperture is configured to correct lens aberration resultant from a subset of the plurality of charged particle beamlets not traveling along a central axis of the focusing column.

3. The variable multibeam charged particle device of any of claims 1 and 2, wherein the variable aperture is positioned in a coma free region between the sample and the multibeam source.

4. The variable multibeam charged particle device of any of claims 1-3, wherein the variable aperture comprises at least a first aperture and a second aperture that has a different size from the first aperture, the variable multibeam charged particle device is configured to translate the variable aperture between a first position and a second position, and wherein:
when the variable aperture is in the first position, one or more charged particle beamlets of the plurality of charged particle beamlets pass through the first aperture, and
when the variable aperture is in the second position, the one or more charged particle beamlets of the plurality of charged particle beamlets pass through the second aperture.

5. The variable multibeam charged particle device of claim 4, wherein:
when the one or more charged particle beamlets of the plurality of charged particle beamlets pass through the first aperture, the plurality of charged particle beamlets have a first current when incident upon the sample; and
when the one or more charged particle beamlets of the plurality of charged particle beamlets pass through the second aperture, the plurality of charged particle beamlets have a second current when incident upon the sample that is different from the first current.

6. The variable multibeam charged particle device of any of claims 1-5, wherein the variable aperture comprises an adjustable aperture that is configured to switch between a first state and a second state, and the adjustable aperture has a different size when it is in the second state than when it is in the first state.

7. The variable multibeam charged particle device of claim 6, wherein:
when the adjustable aperture is in the first state, the plurality of charged particle beamlets have a first current when incident upon the sample; and
when the adjustable aperture is in the second state, the plurality of charged particle beamlets have a second current when incident upon the sample that is different from the first current.

8. The variable multibeam charged particle device of any of claims 1-7, wherein the variable aperture is configured to toggle the device between a single beam mode of operation and a multibeam mode of operation.

9. The variable multibeam charged particle device of claim 8, wherein the variable multibeam charged particle device is configured to translate the variable aperture between a first location and a second location, and wherein:
the variable multibeam charged particle device operates in the multibeam mode of operation when the variable aperture is in the first location; and
the variable multibeam charged particle device operates in the single beam mode of operation when the variable aperture is in the second location.

10. The variable multibeam charged particle device of claim 8, wherein the variable multibeam charged particle device is configured to translate the final crossover between a first location and a second location, and wherein:
the variable multibeam charged particle device operates in the multibeam mode of operation when the final crossover is in the first location; and
the variable multibeam charged particle device operates in the single beam mode of operation when the final crossover is in the second location.

11. The variable multibeam charged particle device of any of claims 1-10, wherein the multibeam source comprises:
a source for producing a beam of charged particles; and
an illuminator configured to convert the beam of charged particles into the plurality of charged particle beamlets.

12. The variable multibeam charged particle device of any of claims 1-11, wherein the objective lens is an inverted magnetic objective lens.

13. The variable multibeam charged particle device of any of claims 1-12, wherein the one or more crossovers include a plurality of crossovers between the multibeam source and the sample.

14. The variable multibeam charged particle device of any of any of claims 1-12, wherein the one or more crossovers include is a single crossover.

15. The variable multibeam charged particle device of any of claims 1-14, wherein the focusing column comprises a booster tube.

16. A method for adjusting the current of a variable multi-beam charged particle device for inspection of a sample, the method comprising:
focusing a plurality of charged particle beamlets from a multi-beam source to be incident upon the sample, wherein focusing the plurality of charged particle beamlets comprises directing the plurality of charged particle beamlets such that there are one or more crossovers of the plurality of charged particle beamlets, wherein each crossover of the one or more crossovers corresponds to a point where the plurality of charged particle beamlets pass through a common location;
varying the current of each of the charged particle beamlets via a variable aperture located at a final crossover of the one or more crossovers that is most proximate to the sample; and
focusing, by an objective lens and onto a detector, charged particles that are emitted by and/or transmitted through the sample.

17. The method of claim 16, wherein the varying the current of each of the charged particle beamlets comprises correcting lens aberration resultant from a subset of the plurality of charged particle beamlets not traveling along a central axis of the variable multi-beam charged particle device.

18. The method of any of claims 16 and 17, wherein the variable aperture comprises an adjustable aperture, the final crossover of the one or more crossovers passes through the adjustable aperture, and wherein the varying the current of each of the charged particle beamlets comprises adjusting a size of the variable aperture.

19. The method of any of claims 16 and 17, wherein the variable aperture comprises at least a first aperture and a second aperture, wherein the first aperture has a different size from the second aperture, and wherein the varying the current of each of the charged particle beamlets comprises translating the variable aperture between:
a first position where one or more charged particle beamlets of the plurality of charged particle beamlets pass through the first aperture; and
a second position where the one or more charged particle beamlets of the plurality of charged particle beamlets pass through the second aperture.

20. The method of any of claims 16-19, further comprising toggling the variable multi-beam charged particle device between a multi-beam mode of operation and a single beam mode of operation.
